# EUROPÄISCHE PATENTANMELDUNG

(11) **EP 4 610 098 A1**
(43) Veröffentlichungstag der Anmeldung: **03.09.2025**
(21) Anmeldenummer: 25159151.7
(22) Anmeldetag: 20.02.2025
(51) Int. Cl.: B60L 53/31, G01R 31/40, G01R 31/50, G01R 31/52, G01R 31/56, H05K 5/00, H05K 5/02, H05K 7/20, B60L 3/12, B60L 53/66

(54) **MOBILER LADESÄULENTESTER**

(30) Priorität: 27.02.2024 DE 102024105391
(71) Anmelder: Jovyatlas GmbH, 26844 Jemgum (DE)
(72) Erfinder: Pastoor, Wolfgang, 26844 Jemgum (DE); Straub, Alexander, 26844 Jemgum (DE)
(74) Vertreter: Grättinger Möhring von Poschinger Patentanwälte Partnerschaft mbB

(57) **Zusammenfassung**

Die vorliegende Erfindung betrifft einen mobilen Ladesäulentester (1) geeignet zur Montage in einem Laderaum (35) eines Kastenwagens (32). Der Ladesäulentester umfasst ein Gehäuse (2) mit einem Gehäuselufteinlass (9) und einem Gehäuseluftauslass (10), eine im Gehäuse (2) angeordnete Lastwiderstandseinheit (11), die geeignet ist elektrischen Strom in thermische Energie umzuwandeln, eine im Gehäuse (2) angeordnete Gebläseeinheit (12), mittels derer ein Luftstrom (L) vom Gehäuselufteinlass (9) durch die Lastwiderstandseinheit (11) zum Gehäuseluftauslass (10) förderbar ist, und einen Abluftkanal (20) mit einem Ablufteinlass (21) und einem Abluftauslass (22). Der Abluftkanal (20) ist in einer Betriebskonfiguration und in einer Transportkonfiguration bezüglich des Gehäuses (2) positionierbar, wobei insbesondere der Abluftauslass (22) des Abluftkanals (20) in der Betriebskonfiguration weiter vom Gehäuse (2) beabstandet ist als in der Transportkonfiguration.

## Beschreibung

Die vorliegende Erfindung betrifft einen mobilen Ladesäulentester.

Mit der zunehmenden Bedeutung der Elektromobilität und der damit einhergehenden wachsenden Anzahl von Ladesäulen für Elektrofahrzeuge, gewinnt die Funktionsprüfung, Wartung, Reparatur, Kalibrierung und Eichung von Ladesäulen immer mehr an Bedeutung.

In diesem Zusammenhang können mobile Ladesäulentester eingesetzt werden, die zu der zu testenden, in der Regel ortsfesten Ladesäule transportiert werden können. Der mobile Ladesäulentester wird vor Ort über ein Ladekabel mit der zu testenden Ladesäulen verbunden und gibt sich gegenüber der zu testenden Ladesäule als ein zu beladendes Elektrofahrzeug aus. Während des Ladevorgangs können dann eine Vielzahl von Parametern, wie beispielsweise die aktuelle Stromstärke und Stromspannung, erfasst und ausgewertet werden. Die daraus abgeleiteten Erkenntnisses hinsichtlich der Funktionsweise und des Zustands der Ladesäule können dann verwendet werden, um beispielsweise eine Reparaturmaßnahme zu definieren oder einzuleiten oder um den eichrechtskonformen Zustand der Ladesäule zu bestätigen.

Die bei einem solchen Test der Ladesäule entnommene elektrische Energie wird dabei typischerweise mittels eines Lastwiderstandes in Wärmeenergie umgewandelt und als Abwärme an die Umgebung abgeführt.

In KR 2313 121 B1 wird ein derartiger mobiler Ladesäulentester beschrieben, der eine Testeinheit und eine Lastwiderstandseinheit aufweist.

Die DE 10 2018 131354 A1 offenbart eine mobile Vorrichtung zum Testen einer Ladestation für Elektrofahrzeuge mit einer Schnittstelle zum Anschluss der Vorrichtung an die Ladestation, einem Kommunikationssystem, einer Steuereinheit, einem DC-Bus und einem ersten Lastmodul sowie einem zweiten Lastmodul.

In der DE 10 2022 110361 A1 wird eine Vorrichtung zur Simulation eines batterieelektrischen Fahrzeugs an einer Ladestation beschrieben. Die Vorrichtung weist dabei einen Profilspeicher, in dem verschiedene Fahrzeugprofile speicherbar sind, sowie eine Simulationseinheit auf, die zum Simulieren eines Fahrzeugs gemäß dem ausgewählten Fahrzeugprofil ausgebildet ist.

Die DE 10 2014 013870 A1 offenbart ein mobiles Prüfsystem einer Automobil-Ladestation umfassend ein Fahrzeug mit einer eingebauten Messeinrichtung zum Testen der Automobil-Ladestation.

Ausgehend von diesem Stand der Technik liegt der vorliegenden Erfindung die Aufgabe zugrunde, einen mobilen Ladesäulentester bereitzustellen, der sich durch eine verbesserte Praxistauglichkeit auszeichnet, insbesondere im Hinblick auf die Vereinfachung des Testvorgangs für den Bediener und die Ermöglichung des Testens von Ladesäulen unabhängig von den aktuellen Wetterbedingungen.

Gelöst wird diese Aufgabe durch den mobilen Ladesäulentester gemäß Anspruch 1 sowie das Ladesäulentestfahrzeug gemäß Anspruch 11.

Der mobile Ladesäulentester (geeignet zur Montage in einem Laderaum eines Kastenwagens) umfasst
- ein Gehäuse mit einem Gehäuselufteinlass und einem Gehäuseluftauslass,
- eine im Gehäuse angeordnete Lastwiderstandseinheit, die geeignet ist elektrischen Strom in thermische Energie umzuwandeln,
- eine im Gehäuse angeordnete Gebläseeinheit, mittels derer ein Luftstrom vom Gehäuselufteinlass durch die Lastwiderstandseinheit zum Gehäuseluftauslass förderbar ist, und
- einen Abluftkanal mit einem Ablufteinlass und einem Abluftauslass,
wobei
- der Abluftkanal in einer Betriebskonfiguration und in einer Transportkonfiguration bezüglich des Gehäuses positionierbar ist, und
- der Abluftauslass des Abluftkanals in der Betriebskonfiguration weiter vom Gehäuse beabstandet ist als in der Transportkonfiguration.

Das synergetische Zusammenspiel der Erfindungsmerkmale ermöglicht dabei eine Gesamtsystem, das den Testvorgang deutlich vereinfacht und (weitestgehend) wetterunabhängig durchführbar macht.

Zum einen ermöglich der erfindungsgemäße Ladesäulentester die effiziente Abfuhr der Abwärme über den in der Betriebskonfiguration positionierten Abluftkanal. Die Abwärme wird auf diese Weise von dem mobilen Ladesäulentester weggeleitet und somit die Temperatur in unmittelbarer Umgebung abgesenkt, was den Testvorgang für den sich in der Nähe des Ladesäulentesters aufhaltenden Bediener komfortabler macht und gleichzeitig die Lebensdauer der Messtechnik und der Lastwiderstandseinheit aufgrund der geringeren thermischen Belastung erhöht.

Weiterhin ist es durch die Positionierung des Abluftkanals in der Transportkonfiguration ermöglich, die Transportabmessungen des mobilen Ladesäulentesters zu reduzieren, was den Transport maßgeblich erleichtert. Zudem ist der Abluftkanal besser vor Beschädigungen während des Transports geschützt, da er weniger weit über das (kompakte) Gehäuse des Ladesäulentesters hinausragt und somit weniger Angriffsfläche für Kollisionen bietet.

Weiterhin kann der erfindungsgemäße Ladesäulentester in einem Kastenwagen montiert und betrieben werden und muss während des Testvorgangs vor Ort nicht ins Freie geschafft werden, um eine ausreichende Wärmeabfuhr sicherzustellen. Ein Kastenwagen ist dabei ein Nutzfahrzeug mit einem nach allen Seiten hin umschlossenen Laderaum, der insbesondere über ein oder zwei schwenkende Klappen (Türen) zugänglich ist.

Hierzu wird der mobile Ladesäulentester im Laderaum des Kastenwagens in der Nähe der Türen montiert und zwar dergestalt, dass die Türen geschlossen werden können, wenn sich der mobile Ladesäulentester in der Transportkonfiguration befindet.

Um eine Ladesäule zu testen wird der Kastenwagen vor der zu testenden Ladesäule abgestellt, wobei die Türen des Laderaums der zu testenden Ladesäule zugewandt sind. Zum Testen werden die Türen geöffnet und der mobile Ladesäulentester in die Betriebskonfiguration gebracht, in dem der Abluftkanal entsprechend positioniert wird.

Der Ladesäulentester wurde dabei derart im Laderaum des Kastenwagens positioniert, dass sich der Abluftauslass des Abluftkanals in der Betriebskonfiguration außerhalb des Laderaums befindet, sodass eine Abfuhr der Abwärme aus dem Laderaum heraus ermöglicht wird. Auf diese Weise ist das Gehäuse des Ladesäulentesters auch bei offenen Türen im Laderaum weitestgehend von Umwelteinflüssen abgeschirmt, sodass ein Testen von Ladesäulen auch bei Niederschlag und damit wetterunabhängig möglich ist.

Unter dem Abstand zwischen dem Abluftauslass des Abluftkanals und dem Gehäuse ist die kürzeste Entfernung zwischen dem Abluftauslass des Abluftkanals und dem Gehäuse zu verstehen.

Gemäß einer ersten bevorzugten Ausgestaltung der Erfindung lässt sich ein in der Transportkonfiguration besonders kompakter, robuster und leicht von der einen in die andere Konfiguration überführbarer Ladesäulentester realisieren, wenn

- der Abluftkanal einen Teleskopkanalabschnitt umfasst, der
über den Gehäuseluftauslass in das Gehäuse einschiebbar und herausziehbar ist,
- in der Betriebskonfiguration der Teleskopkanalabschnitt aus dem Gehäuse herausgezogen ist, und
- in der Transportkonfiguration der Teleskopkanalabschnitt in das Gehäuse eingeschoben ist.

Weiterhin kann vorgesehen sein, dass der Abluftkanal einen Umlenkkanalabschnitt umfasst, mittels dessen die Strömungsrichtung des über den Ablufteinlass in den Abluftkanal eintretenden Luftstroms umlenkbar ist.

Auf diese Weise kann der Abwärme-Luftstrom nach oben abgelenkt werden, wodurch die Belästigung der bodennahen Umgebung im mit Lärm und Abwärme noch weiter reduziert werden kann.

In diesem Zusammenhang kann ein besonders leicht von der einen in die andere Konfiguration überführbarer Ladesäulentester realisiert werden, indem der Umlenkanalkanalabschnitt klappbar am Teleskopkanalabschnitt gelagert ist und insbesondere zwei klappbar gegeneinanderen gelagerte Kanalunterabschnitte aufweist.

Ein Abknicken des in der Betriebskonfiguration positionierten Abluftkanals kann verhindert werden, indem gemäß einer weiteren vorteilhaften Ausgestaltung der Erfindung der Abluftkanal in der Betriebskonfiguration mittels einer Stützstrebe fixierbar ist.

Um den Effekt der natürlichen Konvektion zu nutzen und auf diese Weise die Effizienz des Ladesäulentesters noch weiter zu erhöhen, kann vorgesehen sein, dass der Gehäuselufteinlass auf der Unterseite des Gehäuses angeordnet ist und/oder die Gebläseeinheit einen Axiallüfter mit einer vertikal ausgerichteten Drehachse umfasst.

Weiterhin kann in vorteilhafter Weise vorgesehen sein, dass der mobile Ladesäulentester (mindestens) zwei Gehäusefüße umfasst.

Die Montage und Demontage des mobilen Ladesäulentesters kann für den Bediener noch weiter dadurch vereinfacht werden, dass die Unterseite des Gehäuses und die Gehäusefüße derart ausgeführt sind, dass der Ladesäulentester mittels eines Hubwagens an der Unterseite des Gehäuses aufnehmbar ist.

Gemäß einer weiteren vorteilhaften Ausführungsform weist der Ladesäulentester eine Messsystemeinheit auf, mittels der die Stromstärke und/oder die Stromspannung der von dem Ladesäulentester aufgenommenen elektrischen Energie ermittelbar ist.

Dabei kann weiterhin vorgesehen sein, dass die Messsystemeinheit einen (geeichten oder eichbaren) Strommengenzähler, insbesondere einen DC-Strommengenzähler, aufweist, mittels dem die von dem Ladesäulentester aufgenommene Strommenge ermittelbar ist.

Weiterhin manifestiert sich die Erfindung in dem erfindungsgemäßen Ladesäulentestfahrzeug. Das Ladesäulentestfahrzeug umfasst einen erfindungsgemäßen mobilen Ladesäulentester und ein als Kastenwagen ausgebildetes Transportfahrzeug mit einem Laderaum und mindestens einer schwenkbaren Klappe, wobei
- der Laderaum durch Schwenken der mindestens einen Klappe in einen geöffneten Zustand (geöffneter Laderaum) und einen geschlossenen Zustand (geschlossener Laderaum) bringbar ist, und
- der mobile Ladesäulentester derart im Laderaum positioniert ist, dass in der Transportkonfiguration des Ladesäulentesters der Laderaum in den geschlossenen Zustand bringbar ist, und
- dass im geöffneten Zustand des Laderaums, der mobile Ladesäulentester in die Betriebskonfiguration bringbar ist, in der der Abluftauslass des Abluftkanals außerhalb des Laderaums angeordnet ist.

Nachfolgend wird ein Ausführungsbeispiel der Erfindung anhand der Zeichnung näher erläutert. Dabei zeigt
- Fig. 1: einen mobilen Ladesäulentester in der Transportkonfiguration in einer perspektivischen Schrägansicht,
- Fig. 2: den mobilen Ladesäulentester in der Betriebskonfiguration in einer Seitenansicht,
- Fig. 3: den mobilen Ladesäulentester in der Betriebskonfiguration in einer perspektivischen Schrägansicht,
- Fig. 4A & 4B: den im Laderaum eines Kastenwagens montierten mobilen Ladesäulentester in der Betriebskonfiguration (Fig. 4A) und der Transportkonfiguration (Fig. 4B) jeweils in einer Seitenansicht, und
- Fig. 5: den schematischen Aufbau des Ladesäulentesters mit einer angeschlossenen zu testenden Ladesäule.

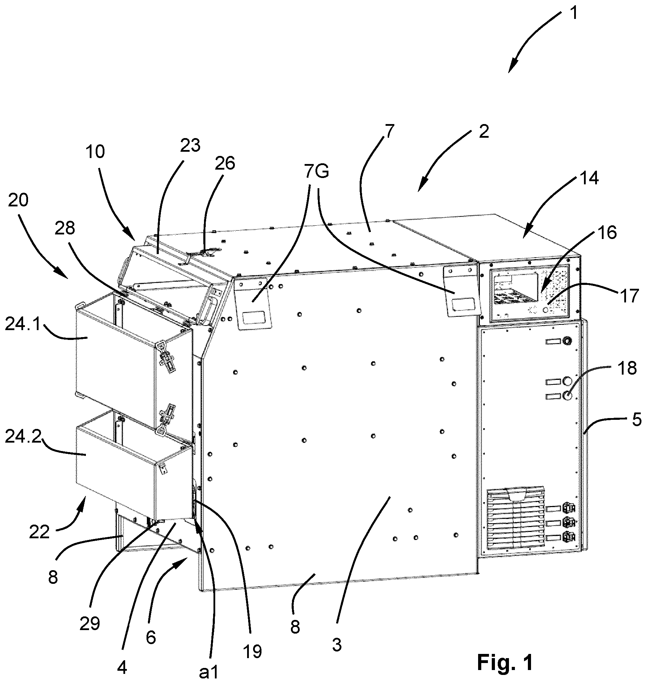

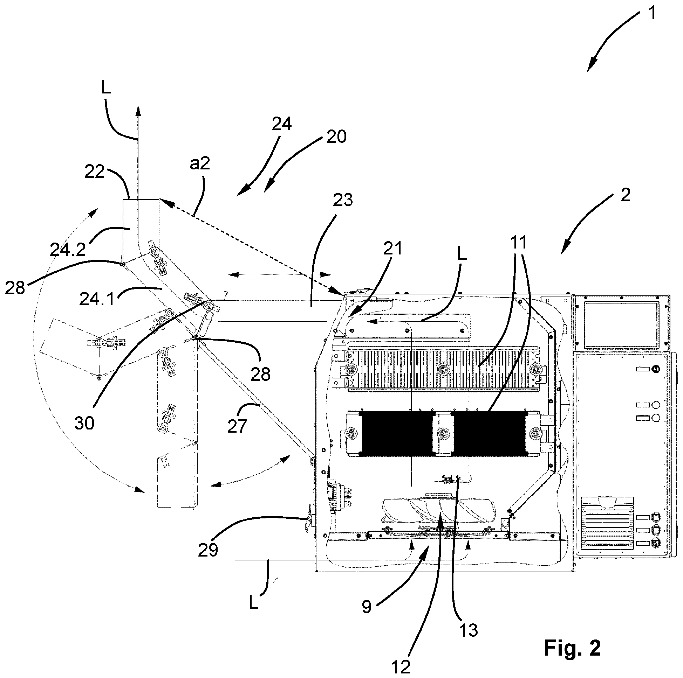

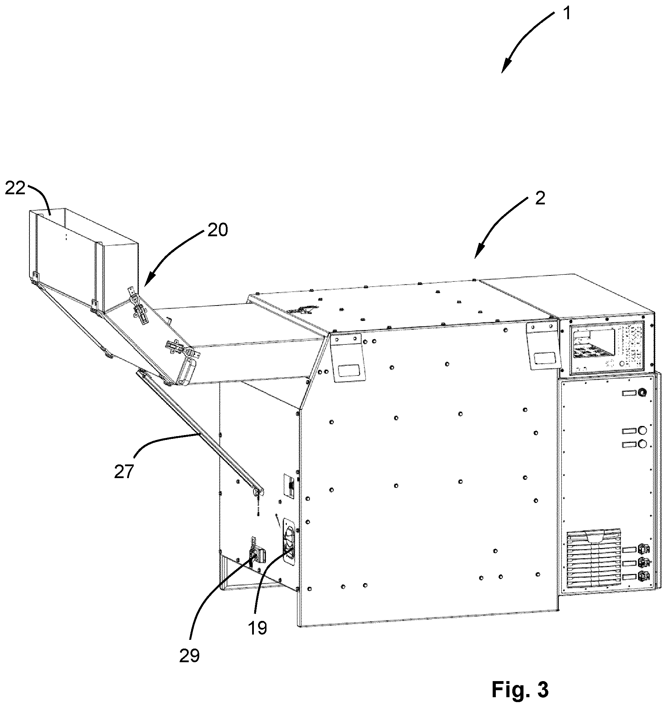

Die Figuren 1 bis 3 zeigen ein Ausführungsbeispiel des erfindungsgemäßen mobilen Ladesäulentesters in der kompakten Transportkonfiguration (Figur 1) und der Betriebskonfiguration (Figuren 2 und 3).

Der mobile Ladesäulentester 1 umfasst ein Gehäuse 2 mit zwei Seitenwänden 3, einer vorderseitigen Stirnwand 4 und einer rückwärtigen Stirnwand 5 sowie einem Boden 6 sowie einem Deckel 7. Die beiden Seitenwände 3 ragen dabei unterseitig über den Boden 6 des Gehäuses 2 hinaus und bilden somit zwei Gehäusefüße 8, die derart voneinander beanstandet sind, dass sie die Gabel eines Hubwagens zwischen sich aufnehmen können. Im Bereich des Deckels 7 sind an den Seitenwänden 3 jeweils zwei Griffe 7G (bzw. Ösen) vorgesehen.

Das Gehäuse 1 weist auf seiner Unterseite, also im Bereich des Bodens 6 des Gehäuses 2, einen Gehäuselufteinlass 9 und an seiner vorderseitigen Stirnwand 4 einen Gehäuseluftauslass 10 auf. Im Gehäuse 2 ist eine Lastwiderstandseinheit 11 (vgl. Figur 2) angeordnet, mittels der elektrischer Strom in thermische Energie umgewandelt werden kann. Eine an den Gehäuselufteinlass 9 angrenzende als Axiallüfter mit vertikal ausgerichteter Drehachse ausgeführte Gebläseeinheit 12 ist dazu eingerichtet, einen Luftstrom L vom Gehäuselufteinlass 9 durch die Lastwiderstandseinheit 11 zum Gehäuseluftauslass 12 zu fördern. Zur Überwachung des Luftstroms und zur Steuerung der Gebläseeinheit 12 umfasst diese einen Windfahnenschaltereinheit 13.

Im Bereich der rückwärtigen Stirnwand 5 des Gehäuses 2 ist eine Messsystemeinheit 14 angeordnet, die einen Strommengenzähler 15, ein Messgerät 16 mit einer Benutzerschnittstelle 17 und einige Bedienschalter 18 aufweist.

In der frontseitigen Stirnwand 4 ist eine Ladebuchse 19 angeordnet, mittels welcher der mobile Ladesäulentester 1 mit einer zu testenden Ladesäule elektrisch verbunden werden kann.

Neben dem Gehäuse 2 weist der mobile Ladesäulentester 1 einen Abluftkanal 20 mit einem Ablufteinlass 21 und einem Abluftauslass 22 auf. Der Abluftkanal 20 umfasst dabei einen Teleskopkanalabschnitt 23 und einen Umlenkkanalabschnitt 24, der wiederum zwei Kanalunterabschnitte 24.1, 24.2 aufweist.

Der Teleskopkanalabschnitt 23 weist Handgriffe 25 auf und ist über den Gehäuselufteinlass 9 in das Gehäuse 2 einschiebbar und herausziehbar, wobei in der in Figur 1 dargestellten Transportkonfiguration der Teleskopkanalabschnitt (vollständig) in das Gehäuse eingeschoben ist und in der in Figur 3 dargestellten Betriebskonfiguration der Teleskopkanalabschnitt 23 (vollständig) aus dem Gehäuse 2 herausgezogen ist. Der Teleskopkanalabschnitt 23 kann mittels eines ersten Spannverschlusses 26 in der Transportkonfiguration und mittels einer Stützstrebe 27 in der Betriebskonfiguration fixiert werden.

Der Umlenkkanalabschnitt 24 ist gegenüber dem Teleskopkanalabschnitt 23 (genauso wieder die beiden Kanalunterabschnitte 24.1, 24.2 untereinander) mittels Scharniere 28 klappbar gelagert.

In der Transportkonfiguration gemäß Figur 1 sind die beiden Kanalunterabschnitte 24.1, 24.2 des Umlenkkanalabschnitts 24 in platzsparender Art und Weise parallel zur vorderseitigen Stirnseite 4 angeordnet und mittels eines zweiten Spannverschlusses 29 in dieser Lage fixiert. Der Abluftauslass 22 des Abluftkanals 20 liegt an der vorderseitigen Stirnseite 4 des Gehäuses 2 (und somit am Gehäuse 2) an. Der Abstand a1 zwischen dem Abluftauslass 22 und dem Gehäuse 2 in der Transportkonfiguration beträgt somit null oder ist zumindest sehr klein.

In der in den Figuren 2 und 3 dargestellten Betriebskonfiguration hingegen sind die Kanalunterabschnitte 24.1, 24.2 des Umlenkkanalabschnitts 24 derart nach oben geklappt und mit dritten Spannverschlüssen 30 in dieser Lage fixiert, dass die einzelnen Abschnitte des Abluftkanals 20 bündig aneinandergrenzen und einen (weitestgehend) dichten Strömungskanal ausbilden, der den horizontal aus dem Gehäuse 2 austretenden Luftstrom L vertikal nach oben hin ablenkt. Der Abluftauslass 22 befindet sich an dem dem Gehäuse 2 abgewandten Ende des Abluftkanals 20. Der Abstand a2 zwischen dem Abluftauslass 22 und dem Gehäuse 2 in der Betriebskonfiguration (Abstand a2) ist damit deutlich größer als in der Transportkonfiguration (Abstand a1).

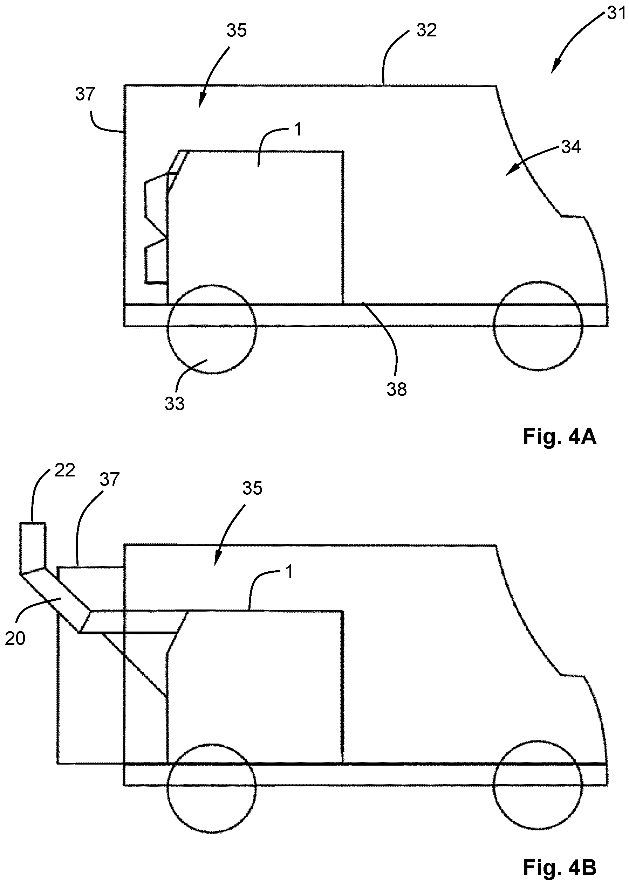

Die Figuren 4A und 4B zeigen ein Ladesäulentestfahrzeug 31 mit einem erfindungsgemäßen mobilen Ladesäulentester 1 und einem als Kastenwagen 32 ausgebildetes Transportfahrzeug.

Der Kastenwagen 32 weist Räder 33, eine Fahrerkabine 34 und einen Laderaum 35 auf, der durch zwei vertikal schwenkbare Türen 37 geöffnet (geöffneter Zustand des Laderaums) und geschlossen (geschlossener Zustand des Laderaums) werden kann.

Der mobile Ladesäulentester 1 ist auf einer Bodenplatte 38 des Laderaums 35 montiert und auf geeignete Weise gegen Verrutschen gesichert.

Gemäß Figur 4A sind die Türen 37 des Kastenwagens 32 geschlossen (geschlossener Zustand des Laderaums) und der mobile Ladesäulentester 1 befindet sich in der in Figur 1 dargestellten Transportkonfiguration.

Gemäß Figur 4B sind die Türen des Kastenwagens 32 geöffnet (geöffneter Zustand des Laderaums) und der mobile Ladesäulentester 1 befindet sich in der in den Figuren 2 und 3 dargestellten Betriebskonfiguration. Dabei ist der Abluftauslass 22 des Abluftkanals 20 außerhalb des Laderaums 35 angeordnet.

Wenn der Kastenwagen anstelle von vertikal schwenkbaren Türen eine horizontal schwenkbare Klappe aufweist, kann es zweckmäßig sein, den Umlenkkanalabschnitt derart auszuführen, dass der Abluftstrom zur Seite des Kastenwagens hin (also weg von der Fahrzeuglängsachse) abgeführt wird. Dabei kann der Umlenkkanalabschnitt vorteilhafterweise so ausgebildet sein, dass er wahlweise alternativ eine Abführung des Abluftstroms zu beiden Fahrzeugseiten hin ermöglicht.

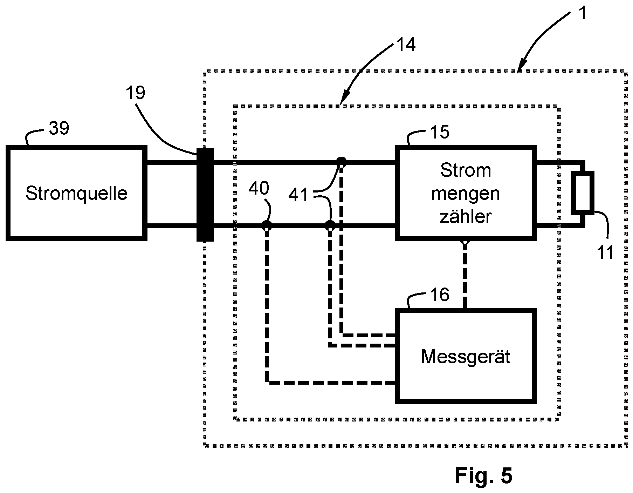

Figur 5 zeigt grob schematisch einen Ausschnitt des elektrotechnischen Aufbaus des mobilen Ladesäulentesters 1 mit einer angeschlossenen zu testenden Ladesäule als Stromquelle 39.

Die Stromquelle 39 ist elektrisch über die Ladebuchse 19 mit dem mobilen Ladesäulentester 1 verbunden. Die Messsystemeinheit 14 umfasst das Messgerät 16 mit der Benutzerschnittstelle 17 und einen geeichten Strommengenzähler 15. Der Strommengenzähler 15 misst die Strommenge, die von der Lastwiderstandseinheit 11 aufgenommen und in thermische Energie umgewandelt wird. Die aufgenommenen Messwerte werden an das Messgerät 16 zur Weiterverarbeitung und/oder Ausgabe übermittelt.

Weiterhin weist die Messsystemeinheit 14 einen Stromstärkemesssensor 40 und Spannungsmesssensoren 41 auf, mittels derer die Stromstärke und die Stromspannung des dem Strommengenzzähler 15 zugeleiteten Stroms gemessen und die zugehörigen Messwerte an das Messgerät 16 übermittelt werden können

**Bezugszeichenliste**

| | |
|---|---|
| Mobiler Ladesäulentester | 1 |
| Gehäuse | 2 |
| Seitenwand | 3 |
| vorderseitigen Stirnwand | 4 |
| rückwärtigen Stirnwand | 5 |
| Boden | 6 |
| Deckel | 7 |
| Griffe | 7G |
| Gehäusefüße | 8 |
| Gehäuselufteinlass | 9 |
| Gehäuseluftauslass | 10 |
| Lastwiderstandseinheit | 11 |
| Gebläseeinheit | 12 |
| Windfahnenschaltereinheit | 13 |
| Messsystemeinheit | 14 |
| Strommengenzähler | 15 |
| Messgerät | 16 |
| Benutzerschnittstelle | 17 |
| Bedienschalter | 18 |
| Ladebuchse | 19 |
| Luftstrom | L |
| Abluftkanal | 20 |
| Ablufteinlass | 21 |
| Abluftauslass | 22 |
| Teleskopkanalabschnitt | 23 |
| Umlenkkanalabschnitt | 24 |
| Kanalunterabschnitte | 24.1, 24.2 |
| Handgriff | 25 |
| erster Spannverschluss | 26 |
| Stützstrebe | 27 |
| Scharnier | 28 |
| zweiter Spannverschluss | 29 |
| Abstand zwischen dem Abluftauslass und dem Gehäuse in der Transportkonfiguration | a1 |
| dritter Spannverschluss | 30 |
| Abstand zwischen dem Abluftauslass und dem Gehäuse in der Betriebskonfiguration | a2 |
| Ladesäulentestfahrzeug | 31 |
| Kastenwagen | 32 |
| Räder | 33 |
| Fahrerkabine | 34 |
| Laderaum | 35 |
| Türen | 37 |
| Bodenplatte | 38 |
| Stromquelle | 39 |
| Stromstärkemesssensor | 40 |
| Spannungsmesssensoren | 41 |

## Patentansprüche

1. Mobiler Ladesäulentester (1) geeignet zur Montage in einem Laderaum (35) eines Kastenwagens (32) umfassend
- ein Gehäuse (2) mit einem Gehäuselufteinlass (9) und einem Gehäuseluftauslass (10),
- eine im Gehäuse (2) angeordnete Lastwiderstandseinheit (11), die geeignet ist elektrischen Strom in thermische Energie umzuwandeln,
- eine im Gehäuse (2) angeordnete Gebläseeinheit (12), mittels derer ein Luftstrom (L) vom Gehäuselufteinlass (9) durch die Lastwiderstandseinheit (11) zum Gehäuseluftauslass (10) förderbar ist, und
- einen Abluftkanal (20) mit einem Ablufteinlass (21) und einem Abluftauslass (22),
wobei
- der Abluftkanal (20) in einer Betriebskonfiguration und in einer Transportkonfiguration bezüglich des Gehäuses (2) positionierbar ist, und
- der Abluftauslass (22) des Abluftkanals (20) in der Betriebskonfiguration weiter vom Gehäuse (2) beabstandet ist als in der Transportkonfiguration.

2. Mobiler Ladesäulentester (1) gemäß Anspruch 1, wobei
- der Abluftkanal (20) einen Teleskopkanalabschnitt (23) umfasst, der über den Gehäuseluftauslass (11) in das Gehäuse (2) einschiebbar und herausziehbar ist,
- in der Betriebskonfiguration der Teleskopkanalabschnitt (23) aus dem Gehäuse (2) herausgezogen ist, und
- in der Transportkonfiguration der Teleskopkanalabschnitt (23) in das Gehäuse (2) eingeschoben ist.

3. Mobiler Ladesäulentester (1) gemäß einem der voranstehenden Ansprüche, wobei der Abluftkanal (20) einen Umlenkkanalabschnitt (24) umfasst, mittels dessen die Strömungsrichtung des über den Ablufteinlass (21) in den Abluftkanal (20) eintretenden Luftstroms (L) umlenkbar ist.

4. Mobiler Ladesäulentester (1) gemäß Anspruch 2 und 3, wobei der Umlenkanalkanalabschnitt (24) klappbar am Teleskopkanalabschnitt (23) gelagert ist und insbesondere zwei klappbar gegeneinander gelagerte Kanalunterabschnitte (24.1, 24.2) aufweist.

5. Mobiler Ladesäulentester (1) gemäß einem der voranstehenden Ansprüche, wobei der Abluftkanal (20) in der Betriebskonfiguration mittels einer Stützstrebe (27) fixierbar ist.

6. Mobiler Ladesäulentester (1) gemäß einem der voranstehenden Ansprüche, wobei der Gehäuselufteinlass (9) auf der Unterseite des Gehäuses (2) angeordnet ist und/oder die Gebläseeinheit (12) einen Axiallüfter mit einer vertikal ausgerichteten Drehachse umfasst.

7. Mobiler Ladesäulentester (1) gemäß einem der voranstehenden Ansprüche, wobei der mobile Ladesäulentester (1) mindestens zwei Gehäusefüße (8) umfasst.

8. Mobiler Ladesäulentester (1) gemäß Anspruch 7, wobei die Unterseite des Gehäuses (2) und die Gehäusefüße (8) derart ausgeführt sind, dass der Ladesäulentester (1) mittels eines Hubwagens an der Unterseite des Gehäuses (2) aufnehmbar ist.

9. Mobiler Ladesäulentester (1) gemäß einem der voranstehenden Ansprüche, wobei der Ladesäulentester (1) eine Messsystemeinheit (14) aufweist, mittels der die Stromstärke und/oder die Stromspannung der von dem Ladesäulentester (1) aufgenommenen elektrischen Energie ermittelbar ist.

10. Mobiler Ladesäulentester (1) gemäß Anspruch 9, wobei die Messsystemeinheit (14) einen Strommengenzähler (15), insbesondere einen DC-Strommengenzähler, aufweist, mittels dem die von dem Ladesäulentester (1) aufgenommene Strommenge ermittelbar ist.

11. Ladesäulentestfahrzeug (31) umfassend einen mobilen Ladesäulentester (1) gemäß einem der voranstehenden Ansprüche und ein als Kastenwagen (32) ausgebildetes Transportfahrzeug mit einem Laderaum (35) und mindestens eine schwenkbare Klappe (37), wobei
- der Laderaum (35) durch Schwenken der mindestens einen Klappe (37) in einen geöffneten Zustand (geöffneter Laderaum) und einen geschlossenen Zustand (geschlossener Laderaum) bringbar ist, und
- der mobile Ladesäulentester (1) derart im Laderaum (35) positioniert ist, dass in der Transportkonfiguration des Ladesäulentesters (1) der Laderaum (35) in den geschlossenen Zustand bringbar ist, und
- dass im geöffneten Zustand des Laderaums (35), der mobile Ladesäulentester (1) in die Betriebskonfiguration bringbar ist, in der der Abluftauslass (22) des Abluftkanals (20) außerhalb des Laderaums (1) angeordnet ist.
